(19) Europäisches Patentamt

European Patent Office

Office européen des brevets

(11) **EP 1 439 424 A2**

(12) **EUROPEAN PATENT APPLICATION**

(43) Date of publication:
21.07.2004 Bulletin 2004/30

(51) Int Cl.⁷: **G03F 7/20**

(21) Application number: **03079204.8**

(22) Date of filing: **31.12.2003**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK** | (72) Inventor: **Tinnemans, Patricius Aloysius Jacobus**<br>**5527 GR Hapert (NL)** |
| (30) Priority: **15.01.2003 EP 03075128** | (74) Representative: **van Westenbrugge, Andries et al**<br>**Nederlandsch Octrooibureau**<br>**Postbus 29720**<br>**2502 LS Den Haag (NL)** |
| (71) Applicant: **ASML Netherlands B.V.**<br>**5503 LA Veldhoven (NL)** | |

(54) **Detection assembly and lithographic projection apparatus provided with such a detection assembly**

(57) The invention comprises an assembly 20 for capacitively detecting an object 21 on a support structure 23 comprising at least one electrode 25 being arranged in the vicinity of the support structure 23, and at least one cable 29 being connected to the at least one electrode 25, said at least one cable 29 having a first conductor 28 and a second conductor 26, said first conductor 28 being connected to a series connection of a DC source 31 and a first AC source 33, and a control device 37 being arranged to:

- control said DC source 31 to provide a predetermined DC voltage to said at least one electrode 25 to provide a clamping force on said object 21, and
- control said first AC source 33 to provide a predetermined first AC voltage with a first amplitude and a first phase via said first conductor 28 to said at least one electrode 25 for capacitively detecting said object 21. New about the invention is that

said assembly 20 comprises a second AC source 35 connected to said second conductor 26 and said control device 37 is arranged to control said second AC source 35 to provide a predetermined second AC voltage to said second conductor 26, said second AC voltage having a second amplitude and a second phase, respectively, which are substantially equal to the first amplitude and first phase, respectively.

*Fig 2*

## Description

The invention relates to a detection assembly for capacitively detecting an object on a support structure comprising at least one electrode being arranged in the vicinity of the support structure, and at least one cable, said at least one cable having a first conductor and a second conductor, said first conductor at a first end being connected to the at least one electrode and at a second end being connected to a first AC source, and a control device being arranged to control said first AC source to provide a predetermined first AC voltage with a first amplitude and a first phase via said first conductor to said at least one electrode for capacitively detecting said object.

Such an assembly can particularly advantageously be provided in a lithographic projection apparatus. The present invention shall therefore hereinafter be illustrated by means of such a lithographic apparatus by way of example only. In a lithographic projection apparatus the presence of an object on a support structure is currently detected by measuring the capacitance of an assembly comprising at least cables connected to the support structure and the support structure itself. It is impossible to measure the capacitance of the support structure only, because the measurement of the capacitance of the support structure is carried out via the cables and is thus influenced by the cables and possibly by the presence of other components in electrical contact with the support structure. The cables in particular, introduce a relatively high additional capacitance in this measurement. The cables are, however, needed to energize electrodes which are used to exert a required electrostatic clamping force on the object. The presence of additional capacitances makes it difficult to establish accurately the relatively small capacitance of the support structure which furthermore varies in accordance with the position of the object. It is important to be able to measure the capacitance of the support structure accurately, among others, for the following reasons. This capacitance:

1) indicates whether the object has been correctly placed and/or clamped on the support structure,
2) gives, after calculation via the formula below, the maximum force which may be exerted on the object without the object becoming detached from the support structure, and
3) enables to establish with a high degree of reliability the presence or absence of an object on the support structure without the need of an additional calibration.

Clearly, it is presently impossible to measure accurately the relatively small variable capacitance of the support structure in a lithographic projection apparatus.

It is therefore an aim of the invention to measure the capacitance of the support structure more accurately.

The invention is therefore in a first embodiment characterized in that said assembly comprises a second AC source connected to said second conductor and said control device is arranged to control said second AC source to provide a predetermined second AC voltage to said second conductor, said second AC voltage having a second amplitude and a second phase, respectively, which are substantially equal to the first amplitude and first phase, respectively.

This allows for an accurate measurement of the capacitance of the support structure and makes it also possible to determine the change in the capacitance of the support structure with a high degree of precision, since, in the measurement, the capacitance of cables and other components that do not comprise the support structure is not measured.

In a further embodiment the invention is characterized in that in said first conductor a DC source is included in series with said first AC source for providing a predetermined DC voltage to said at least one electrode to provide a clamping force on said object. The clamping force ensures an appropriate bonding between the support structure and the object.

In a further embodiment the invention is characterized in that the first conductor of the cable is at least partially enclosed by the second conductor of the cable. The coaxial cable may have any diameter. It may also have a different geometrical shape as long as the braid (outer conductor) shields the inner conductor. Advantageously, the diameter of the conductor is chosen as small as possible to minimize the stiffness of the cable.

In a further embodiment the invention is characterized in that the second conductor is at least partially enclosed by a third grounded conductor. This results in a reduction of electromagnetic radiation from and to the cable.

In still a further embodiment the invention is characterized in that the second AC voltage is obtained from the first AC voltage with the use of an amplifier circuit with an amplification of unity. This will result in that a second AC voltage that is uncoupled from the first AC voltage, though having substantially the same amplitude and phase as the first AC voltage.

The invention also relates to a lithographic apparatus comprising the detection assembly as described above. In a further embodiment of the invention the lithographic projection apparatus further comprises an actuator for moving the support structure, said actuator being connected to the control device, said control device being arranged to control the actuator to move the support structure after establishing that the clamping force is above a predetermined value. This means that the actuator/transport device (e.g. a robot) will carry out a movement only with a certain minimum clamping force present on the object. It may be advantageous to provide the control device with a table with information about typical movements and required clamping forces for the respective movements.

In still a further embodiment the invention is characterized in that the lithographic projection apparatus further comprises an actuator for moving the support structure, which actuator is connected to the control device, the control device being arranged to determine the clamping force on said object and to provide the actuator with a maximum value for the acceleration on said object, accordingly. In this way it is prevented that an object detaches itself from the support structure due to too high an acceleration on the object. Again, it may be advantageous to provide the control device with a table with information about typical clamping forces and respective allowable accelerations for typical transportation movements.

The invention as described in connection with both of the embodiments above can also be used to determine the maximum value for the acceleration on a warped wafer put on the wafer table or on wafer put on the wafer table with a slight tilt.

The invention also relates to a method for capacitively detecting in a lithographic projection apparatus an object on a support structure comprising at least one electrode being arranged in the vicinity of the support structure, and at least one cable being connected to the at least one electrode, said at least one cable having a first conductor and a second conductor, said first conductor being connected to a series connection of a DC source and a first AC source, said method including the steps of:

- controlling said DC source to provide a predetermined DC voltage to said at least one electrode to provide a clamping force on said object, and
- controlling said AC source to provide a predetermined first AC voltage with a first amplitude and a first phase via said first conductor to said at least one electrode for capacitively detecting said object,

characterized in that
said assembly comprises a second AC source connected to said second conductor, and that said method comprises the step of controlling said second AC source to provide a predetermined second AC voltage to said second conductor, said second AC voltage having a second amplitude and a second phase, respectively, which are substantially equal to the first amplitude and first phase, respectively.

The invention further relates to a method used to calibrate the detection assembly as described above, or the lithographic projection apparatus as described above,
characterized in that the method comprises:

- determining at least one of a first capacitance of the support structure with the object present on the support structure and a second capacitance of the support structure without the object present on the support structure, and
- storing at least one of the determined first capacitance and the determined second capacitance in a memory.

The invention further relates to a method as described above to establish whether or not a support structure and an object may be moved together, characterized in that the method comprises the steps of:

- determining the clamping force of the support structure on the object by determining the difference in capacitance between the support structure with the object present on the support structure and the support structure without the object present on the support structure,
- comparing the clamping force to a predetermined minimum clamping force required to hold the object on the support structure during the movement; and
- either making the movement when the determined clamping force is more than the minimum clamping force, or refraining from making the movement when the determined clamping force is less than the minimum clamping force.

The invention further relates to a method as described above used to keep the acceleration of the support structure and the object during a movement below a predetermined value, characterized in that the method comprises the steps of:

- determining the clamping force of the support structure on the object by determining the difference in capacitance between the support structure with the object present on the support structure and the support structure without the object present on the support structure, and
- carrying out the movement with an acceleration less than the maximum acceleration.

The invention further relates to a computer program product comprising instructions and data to allow an assembly to perform any of the methods as above previously.

The invention further relates to a data carrier comprising a computer program product as described above.

The term "patterning means" should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;

- A programmable mirror array. One example of such a device is a matrix-addressable surface having a visco-elastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and

- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

The invention will now be explained in connection with the accompanying drawings, which are only intended to show examples and not to limit the scope of protection, and in which:

Fig. 1 is a schematic general overview of a lithographic projection apparatus ,
Fig. 2 shows a schematic setup of an embodiment of the invention,

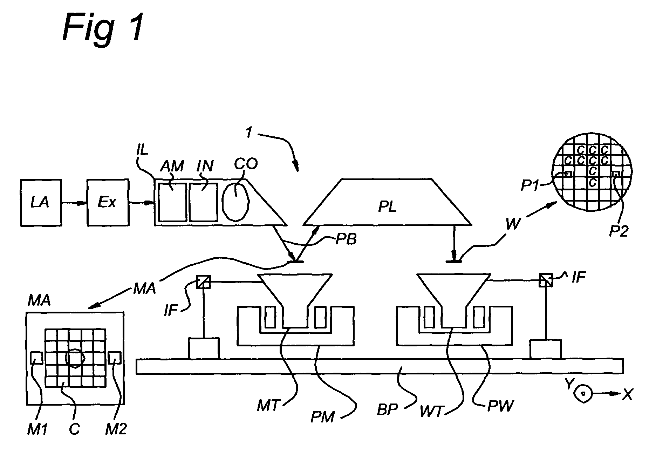

Fig. 1 schematically depicts a lithographic projection apparatus 1 according to a particular embodiment of the invention.

The apparatus comprises:

- a radiation system Ex, IL, for supplying a projection beam PB of radiation (e.g. EUV radiation) with a wavelength of 11-14 nm. In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e. g. a resist-coated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W. As here depicted, the apparatus is of a reflective type (i.e. has a reflective mask). However, in general, it may also be of a transmissive type, for example (with a transmissive mask). Alternatively, the apparatus may employ another kind of patterning means, such as a programmable mirror array of a type as referred to above.

The source LA (e.g. a laser-produced plasma or a discharge plasma EUV radiation source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as $\sigma$-outer and $\sigma$-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Fig. 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:

> 1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
> 2. In scan mode, essentially the same scenario applies, except that a given target portion C is not exposed in a single "flash". Instead, the mask table MT is movable in a given direction (the so-called "scan direction", e.g. the y direction) with a speed $v$, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

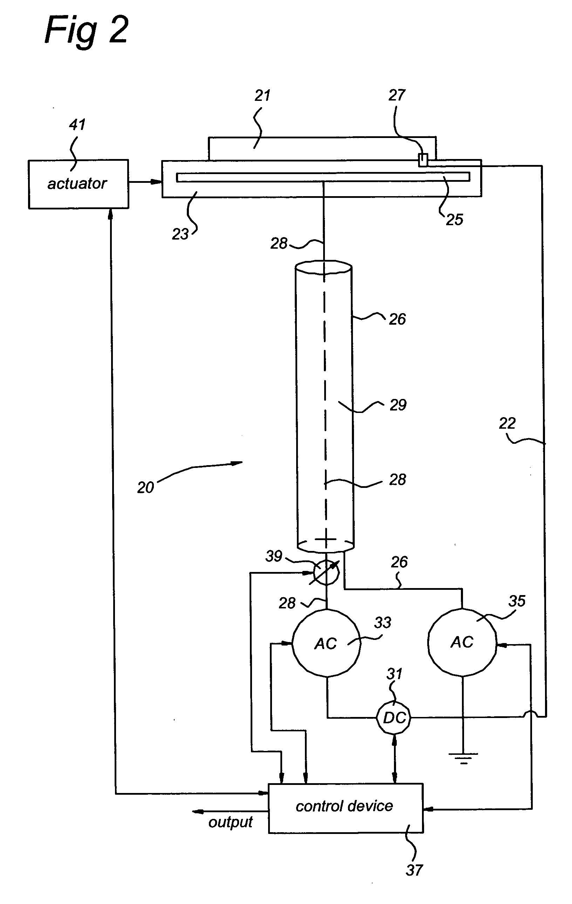

In figure 2 an embodiment of the invention is shown. A detection assembly 20 comprises a support structure 23 (e.g. wafer table) on which an object 21 (e.g. wafer) is mounted or "clamped". The support structure 23 comprises a first electrode 25. The electrode 25 may consist of multiple sections. For example, two halve circularly shaped "D's", which would result in a system with two identical circuits each connected to their respective electrode parts. A second (counter) electrode 27 is in electrical contact with the object 21. The first electrode 25 is connected to a conductor 28 and the second electrode to a conductor 22. As shown in figure 2, the conductor 28 may be an inner conductor of a coax cable 29. The outer braid of the coax cable 29 is formed by a conductor 26. This is important, the inner conductor 28 must not see its environment electrically. The cable 29 is connected to a DC voltage source 31. In series with the DC voltage source 31, an AC voltage source 33 is connected. Another AC voltage source 35 is connected to the outer conductor 26 in parallel with the DC voltage source 31. The shielding, effected by the conductor 26, and the additional AC source 35 yield the required result. The DC voltage source 31, the AC voltage source 33 and the AC voltage source 35 are each connected to a control unit 37.

A (current) measurement unit 39 is provided, e.g., in conductor 28 to measure the current flowing in conductor 28. The current measurement unit 39 is connected to the control unit 37. The unit 39 may be connected in between the AC voltage source 33 and the cable 29 (as shown in fig 2) or between the cable 29 and the wafer table 23. Also, when a resonant circuit solution is chosen, the change in frequency can be measured by the measurement unit 39. An actuator 41 is provided to move the support structure as desired and as controlled by control unit 37.

The assembly 20 operates in the following way: the DC voltage source provides the electrodes 25 and 27 with a DC voltage. The DC voltage generates an electric field in between the electrodes 25 and 27. The electric field provides the attracting clamping force on the object 21 to the support structure 23. To measure the capacitance of the assembly 20 the AC voltage source 33 is used. The capacitance value is then calculated by the control unit 37, using the AC value of the AC source 33 and the current value provided by current measurement unit 39, as is known to persons skilled in the art. The capacitance value measured is larger when the object (e.g., wafer) is present than when the object is not present. Therefore, the capacitance measurement provides information as to whether or not the object is present.

However, the capacitance measurement is strongly influenced by the capacitance of the cable 29 since the latter capacitance is much larger than the capacitance difference due to whether or not object 21 is present. Therefore, the setup of figure 2 is arranged such that it eliminates the capacitance of the cable 29 in the measurement.

To eliminate the capacitance of the cable 29 from this measurement, the AC voltage source 35 provides an AC voltage to the outer conductor 26 which is of the same phase and has the same amplitude as the AC voltage provided by the AC voltage source 33 to the inner conductor 28. Thus the voltage difference across the two conductors 26, 28 will be zero and the cable 29 will not add to the capacitance of the assembly 20.

The assembly of figure 2 provides for a more accurate measurement of the capacitance contribution due to the object 21. E.g., it is envisaged that deviations from an ideal, expected capacitance value can now be measured more easily. Such deviations may, e.g., be caused by a deviation of an expected flatness of a clamped wafer.

Moreover, absolute values of the capacitance measurement now provide accurate and reliable indications whether or not the object 21 is present. Thus, when the arrangement of figure 2 is used in the lithography system of figure 1, measuring the capacitance when the system is switched on, may directly and unambiguously provide an indication whether a wafer is present. This avoids the need for a complicated calibration measurement.

In a further embodiment, the arrangement of figure 2 is used to calculate an electrostatic clamping pressure exerted by electrode 25 to the object 21 to clamp the latter. To that end, the capacitance is measured twice, i.e., once with the object 21 present and once without the object 21 being present. When the difference in capacitance value between these two measurements is defined to be ? C, the electrostatic clamping pressure P follows for a single electrode setup, where the capacity is measured between the electrode 25 and the wafer 21, from:

$$P = \frac{1}{2\varepsilon_0 A^2} \cdot V^2 \cdot \Delta C^2 \qquad [Pa]$$

in which:

A     = surface area of object 21
V     = voltage of DC source 31
$e_0$     = dielectric constant of vacuum.

For a bipolar setup, where the capacity between two electrodes is measured, with the wafer electrically floating in between, the above formula changes to:

$$P = \frac{8}{\varepsilon_0 A^2} \cdot V^2 \cdot \Delta C^2 \qquad [Pa]$$

in which the same symbols as above are used.

Instead of measuring the capacitance without the object 21 being present, alternatively, the capacitance could be measured with a perfectly flat surface present. This second reference measurement combined with the measurement without the object 21 being present could also make it possible to obtain a (linear) calibration graph with known offset and gain for the system.

Knowing this electrostatic clamping pressure P may be important since it can be used as an indication for a maximal allowance acceleration of the object 21 as clamped. When the object is a wafer 21, the maximal allowable acceleration of the support structure 23 with the clamped wafer 21 follows from the electrostatic clamping pressure P multiplied by the friction coefficient of the wafer 21 on the support structure 23. This result, as calculated by control unit 37, may then be used by control unit 37 to control actuator 41 such that actuator 41 provides support structure 23 with an acceleration below said maximal acceleration.

On the other hand, when the control unit 37 knows a maximal acceleration to be exerted on the support structure, it may control DC source 31 to reduce the clamping voltage if control unit 37 has determined that the actual clamping force exceeds a necessary clamping force. This is advantageous, since it may, for example, help to reduce contamination.

As mentioned above, the present invention has been described by means of a lithographic apparatus, it is emphasized however that the description above is given by way of example only and is by no means meant to limit the scope of the present invention.. Although the AC sources 33, 35, the DC source 37 and the control unit 37 are shown as separate units they may be implemented in any other technically equivalent way, e.g., as one single unit connected to the conductors 28, 29 but providing the same functionality. Thus, figure 2 shows the basic functional units but not necessarily the only way of implementation. The control unit 37 may be a computer driven by suitable software. However, analog and/or digital circuits may also be used, as desired. The AC source 35 may be controlled by the AC source 33 such that it multiplies the AC source 35 output AC voltage by unity to obtain an accurate equal AC voltages output.

**Claims**

1.  A detection assembly (20) for capacitively detecting an object (21) on a support structure (23) comprising at least one electrode (25) being arranged in the vicinity of the support structure (23), and at least one cable (29), said at least one cable (29) having a first conductor (28) and a second conductor (26), said first conductor (28) at a first end being connected to the at least one electrode (25) and at a second end being connected to a first AC source (33), and a control device (37) being arranged to control said first AC source (33) to provide a predetermined first AC voltage with a first amplitude and a first phase via said first conductor (28) to said at least one electrode (25) for capacitively detecting said object (21), **characterized in that** said assembly (20) comprises a second AC source (35) connected to said second conductor (26) and said control device (37) is arranged to control said second AC source (35) to provide a predetermined second AC voltage to said second conductor (26), said second AC voltage having a second amplitude and a second phase, respectively, which are substantially equal to the first amplitude and first phase, respectively.

2.  Detection assembly (20) according to claim 1, **characterized in that** in said first conductor (28) a DC source (31) is included in series with said first AC source (33) for providing a predetermined DC voltage to said at least one electrode (25) to provide a clamping force on said object (21).

3. Detection assembly (20) according to claim 1 or 2, **characterized in that** the object (21) is one of a wafer and a reticle.

4. Detection assembly (20) according to any of the preceding claims, **characterized in that** the first conductor (28) of the cable (29) is at least partially enclosed by the second conductor (26) of the cable (29).

5. Detection assembly (20) according to claim 4, **characterized in that** the second conductor (26) is at least partially enclosed by a third grounded conductor.

6. Detection assembly (20) according to any of the preceding claims, **characterized in that** the second AC voltage is obtained from the first AC voltage with the use of an amplifier circuit with an amplification of unity.

7. A lithographic apparatus (1) comprising a detection assembly (20) according to any of the preceding claims.

8. Lithographic projection apparatus (1) according to claim 7, **characterized in that** the lithographic projection apparatus (1) further comprises an actuator (41) for moving the support structure (23), said actuator (41) being connected to the control device (37), said control device (37) being arranged to control the actuator (41) to move the support structure (23) after establishing that the clamping force is above a predetermined value.

9. Lithographic projection apparatus (1) according to claim 7 or 8, **characterized in that** the lithographic projection apparatus (1) further comprises an actuator (4 1 ) for moving the support structure (23), said actuator (4 1 ) being connected to the control device (37), said control device (37) being arranged to determine the clamping force on said object (21) and to provide the actuator (41) with a maximum value for the acceleration on said object (21), accordingly.

10. Method for capacitively detecting an object on a support structure (23) comprising at least one electrode (25) being arranged in the vicinity of the support structure (23), and at least one cable (29) being connected to the at least one electrode (25), said at least one cable (29) having a first conductor (28) and a second conductor (26), said first conductor (28) being connected to a series connection of a DC source (31) and a first AC source (33), said method including:

- controlling said DC source (31) to provide a predetermined DC voltage to said at least one electrode (25) to provide a clamping force on said object (21), and
- controlling said AC source (33) to provide a predetermined first AC voltage with a first amplitude and a first phase via said first conductor (28) to said at least one electrode (25) for capacitively detecting said object (21),

**characterized in that**
said assembly comprises a second AC source (35) connected to said second conductor (26), and **in that** said method comprises the step of controlling said second AC source (35) to provide a predetermined second AC voltage to said second conductor (26), said second AC voltage having a second amplitude and a second phase, respectively, which are substantially equal to the first amplitude and first phase, respectively.

11. Method according to claim 10 used to calibrate a detection assembly (20) according to any of the claims 1 to 6, or a lithographic projection apparatus (1) according to any of the claims 7 to 9, **characterized in that** the method comprises:

- determining at least one of a first capacitance of the support structure (23) with the object (21) present on the support structure (23) and a second capacitance of the support structure (23) without the object (21) present on the support structure (23), and
- storing at least one of the determined first capacitance and the determined second capacitance in a memory.

12. Method according to claim 10 or 11 used to establish whether or not the support structure (23) and the object (21) may be moved together, **characterized in that** the method comprises:

- determining the clamping force of the support structure (23) on the object (21) by determining the difference in capacitance between the support structure (23) with the object (21) present on the support structure (23) and the support structure (23) without the object (21) present on the support structure (23),
- comparing the clamping force to a predetermined minimum clamping force required to hold the object (21) on the support structure (23) during the movement, and
- either making the movement when the determined clamping force is more than or equal to the minimum clamping force, or refraining from making the movement when the determined clamping force is less than the minimum clamping force.

13. Method according to claim 10, 11, or 12 used to keep the acceleration of the support structure (23) and the object (21) during a movement below a predetermined value, **characterized in that** the method comprises:

   - determining the clamping force of the support structure (23) on the object (21) by determining the difference in capacitance between the support structure (23) with the object (21) present on the support structure (23) and the support structure (23) without the object (21) present on the support structure (23),
   - deriving from the clamping force the maximum acceleration which causes movement of the support structure (23) relative to the object (21), and
   - carrying out the movement with an acceleration less than the maximum acceleration.

14. Computer program product comprising instructions and data to allow a detection assembly (20) to perform any of the methods according to claims 10 to 13.

15. Data carrier comprising a computer program product according to claim 14.

## Fig 1

# Fig 2